# EUROPEAN PATENT APPLICATION

(11) **EP 1 819 046 A1**
(43) Date of publication of application: **15.08.2007**
(21) Application number: 06300124.2
(22) Date of filing: 10.02.2006
(51) Int. Cl.: H03K 17/28

(54) **Power supply apparatus with improved slope of supply voltage and respective circuit arrangement**

(71) Applicant: Thomson Licensing S.A., 92100 Boulogne-Billancourt (FR)
(72) Inventor: Bao, You Bing 2F., Park B, Zhen Fu Bao Scie. & Ind, Shenzhen (CN); Luo, Wei 2F.,Park B, Zhen Fu Bao Science & Ind., Shenzhen (CN)
(74) Representative: Arnold, Klaus-Peter

(57) **Abstract**

The power supply apparatus, providing a common supply voltage (Vcc) for two or more circuit parts (1, 2), comprises a delay circuit (D) being arranged in a supply line of the supply voltage (Vcc) ahead of at least one of the circuit parts (1, 2). The power supply apparatus comprises in particular a switched mode power supply including a soft-start feature for a start-up. With this arrangement, it is avoided that any relevant circuit part is reset too early, or respectively to late, when the supply voltage after start-up of the power supply apparatus rises slowly. The circuit parts are in particular digital circuit parts.

## Description

### FIELD OF THE INVENTION

The present invention relates to a power supply apparatus for providing a common supply voltage for two or more circuit parts, and to a circuit arrangement comprising a respective power supply apparatus. A circuit arrangement of this kind may be utilized for example within a consumer electronics appliance. The power supply apparatus is in particular a switched mode power supply comprising a soft start function.

### BACKGROUND

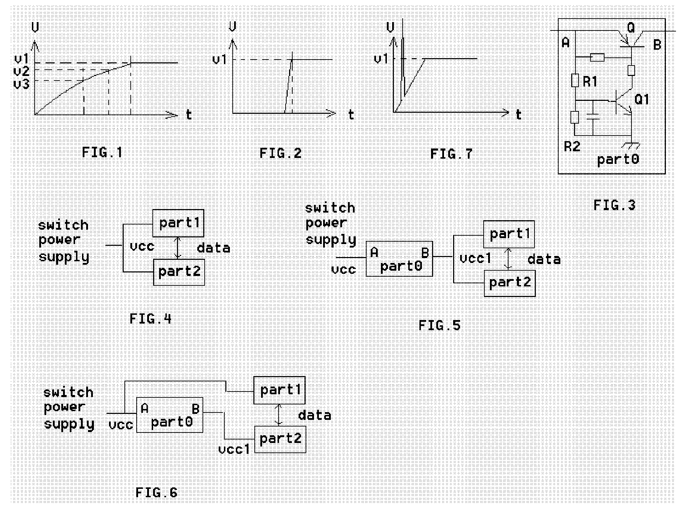

It is well known that a switched power supply apparatus, for example a mains operated switched mode power supply, may produce a sharp peak of an output supply voltage, when the power supply apparatus is switched on and subsequently starts up. This voltage peak may even exceed the required voltage value of the output supply voltage, as shown in figure 2. A voltage peak of this kind generates unwanted electromagnetic inferences EMI and may even destroy the load, e.g. an integrated circuit, for which the supply voltage is intended.

To overcome the problem, the power supply apparatus is often equipped with a so called soft-start function, which is in many cases already included within an integrated controller circuit of the power supply apparatus. With the soft-start function, the supply voltage of the power supply apparatus rises slowly without any voltage spikes, as shown in figure 1 for example.

If a supply voltage Vcc is used to provide power to two or more circuit parts, for example a main digital circuit part 1 and a minor digital circuit part 2, which have a data exchange via a communication channel during operation, as shown in figure 4, the complete system may not work correct. When the voltage Vcc rises as shown in figure 1, it may happen that the circuit part 2 is reset when Vcc rises to value v3 and circuit part 1 is reset, when the supply voltage Vcc rises to a higher value v2, because of different IC technologies. The circuit part 2 in this case starts operating before the circuit part 1, and the whole system may remain then in an undefined state.

### SUMMARY OF THE INVENTION

It is the object of the present invention to provide a power supply apparatus for two or more circuit parts and a respective circuit arrangement, which comprise a stable common supply voltage for a safe start up of the circuit parts.

This object is achieved for a power supply apparatus as described in claim 1 and for a circuit arrangement as described in claim 8. Preferred embodiments of the invention are described in the dependent claims.

The power supply apparatus for providing a common supply voltage for two or more circuit parts according to the invention comprises a delay circuit being arranged ahead of at least one of the circuit parts. The supply voltage is supplied to the circuit parts via a supply line, and the delay circuit is arranged in the supply line before the supply voltage is split up for the respective circuit parts, or the delay circuit is arranged after the split up of the supply line in front of one of the circuit parts. The circuit parts are in particular digital circuit parts.

With this arrangement, it is avoided that any relevant circuit part is reset too early, or respectively to late, when the supply voltage after start-up of the power supply apparatus rises slowly, which is in particular the case when the power supply apparatus comprises a switched mode power supply including a soft start feature.

In a further aspect of the invention, one of the circuit parts is a main digital circuit part and a second one is a minor digital circuit part, which have a communication channel for a data exchange between both digital circuit parts. In this embodiment the delay circuit is arranged after the branching of the supply voltage for delaying only the start-up of the minor circuit part. With this arrangement, the power losses in the delay circuit can be reduced therefore.

In a preferred embodiment, the delay circuit comprises a switching stage with a transistor switch and a capacitor for a delayed switching through of the supply voltage. The supply voltage may be coupled in particular via a voltage divider to a control input of a transistor switch, to which in addition the capacitor is coupled for charging the capacitor with a delay. When the voltage across the capacitor reaches a specified threshold, the switching stage switches through for providing the supply voltage for a respective digital circuit part.

### SHORT DESCRIPTION OF THE DRAWINGS

Preferred embodiments of the invention are explained now in more detail with regard to schematic drawings, which show:
- Fig. 1: a voltage diagram of a supply voltage, as supplied by a switched mode power supply comprising a soft start feature, after switching on of the switched mode power supply,
- Fig. 2: a voltage diagram of a supply voltage, as provided after switching on by a power supply apparatus without a soft start feature,
- Fig. 3: a voltage diagram showing a supply voltage generated by a power supply apparatus according to the invention after switching on,
- Fig. 4: a power supply apparatus providing a common supply voltage for two digital circuit parts according to prior art,
- Fig. 5: a power supply apparatus comprising a delay circuit in accordance with the invention,
- Fig. 6: a preferred embodiment of the delay circuit of figure 5, and
- Fig. 7: a second embodiment of a power supply apparatus according to the invention comprising a delay circuit for only one of the digital circuit parts.

### PREFERRED EMBODIMENTS OF THE INVENTION

The circuit arrangement shown in figure 5 comprises a power supply apparatus 3 and two digital circuit parts 1 and 2, which are supplied with a common supply voltage Vcc by the power supply apparatus 3. In the supply line of the supply voltage Vcc a delay circuit D comprising an input A and an output B is arranged, for providing the supply voltage Vcc with a delay to the digital circuit parts 1 and 2, when the power supply apparatus 3 is switched on.

The power supply apparatus 3 is in particular a switched mode power supply comprising a soft start feature for the start up. A power supply apparatus of this kind provides a rising supply voltage Vcc after switching on of the power supply apparatus, as shown in figure 1 and already explained before. An integrated controller circuit providing a soft start for a switched mode power supply is for example the integrated circuit FSDM0265RL manufactured by Fairchild Semiconductor Corporation. Details about the soft start function and typical application circuits can be found in respective data sheets of this integrated circuit. The delay time t1 can be in the range of milliseconds, for example above 100 msec.

With the delay circuit D included within the power supply apparatus 3, the supply voltage Vcc1 available at the output B of the delay circuit D is applied to the digital circuit parts 1, 2 with a delay t1 with regard to a switch on at time t=0, as shown in figure 3. During the time interval 0 - t1, a switching stage of the delay circuit D is blocked. The time t1 is arranged for example such, that the supply voltage Vcc has reached already the wanted voltage level v1. In this case, the supply voltage Vcc1 reaches within a very short time the supply voltage level v1, as shown in figure 3. The digital circuit parts 1, 2 are reset therefore essentially at the same time and the circuit arrangement will work normally.

A preferred embodiment of the delay circuit D is shown in figure 6. The delay circuit D comprises a voltage divider with resistors R1, R2 being arranged between the input A and ground, and a switching stage with switching transistors Q1 and Q2. A tap of the voltage divider and a capacitor C is connected to an input terminal of transistor Q1 for switching through the transistor Q1, when a specified threshold is reached, which is defined in this embodiment essentially by the base-emitter voltage of transistor Q1.

A current input of the transistor Q1 is coupled via a resistor R4 to a control input of the transistor Q2 and the current output of transistor Q1 is coupled to ground for switching through the transistor Q2, when the threshold voltage across capacitor C is reached. The transistor Q2 is coupled with a current input to the input A and with a current output to the output B for switching the supply voltage Vcc through, in response to the switching through of the transistor Q1. Between the input A and the control input of the transistor Q2 a resistor R3 is coupled, which keeps transistor Q2 blocked, as long as the transistor Q1 is blocked.

For a supply voltage Vcc of 5 Volts, the circuit parts of the delay circuit D have in a preferred embodiment the following values: R1 = 3,9 kOhm, R2 = 1 kOhm, R3 = 3,9 kOhm, R4 = 1 kOhm and C1 = 10 micro-Farad. These values provide a very fast switching through of both transistors Q1, Q2.

A second embodiment of the invention is shown in figure 7. Here, the supply voltage Vcc from the power supply apparatus 3 is directly coupled to the digital circuit part 1, and the delay circuit D is arranged between the supply voltage Vcc and the digital circuit part 2 for providing the supply voltage Vcc1 for the digital circuit part 2 with a delay with regard to the supply voltage Vcc for the digital circuit part 1, when the power supply apparatus 3 is switched on. With this arrangement, it is also avoided that the digital circuit part 2 resets earlier than the digital circuit part 1. In this embodiment, the power losses in the delay circuit D are considerably reduced.

In a specific application in accordance with figure 7, the digital circuit part 1 is a main circuit part, for example a digital master controller, and the digital circuit part 2 is a minor circuit part, for example an analog-digital converter (ADC), both being arranged within a digital audio amplifier. The communication channel between both circuit parts is used in particular for a transmission of digital audio data. With this circuit arrangement, it is avoided that the analog-digital converter is reset earlier than the digital master controller, when the circuit arrangement is switched on. Because the supply current for the analog-digital converter is small, the losses in the delay circuit D are very low.

With a circuit arrangement as shown in figure 4, it may happen for this specific application that the minor circuit part 2 is reset earlier than the main circuit part 1, which leads to an undefined state, in which noise at the output of the digital audio amplifier may appear.

The digital circuit part 2 is in particular an analog-digital converter and the digital circuit part 1 a digital master controller, as described before with regard to figure 7, but other applications are also within the scope of a person skilled in the art without departing from the scope of the present invention. The invention may be used in particular also for analog circuit parts or a combination of analog and digital circuit parts.

## Claims

1. Power supply apparatus providing a common supply voltage (Vcc) for two or more circuit parts (1, 2), **characterized by** a delay circuit (D) being arranged in a supply line of the supply voltage (Vcc) ahead of at least one of the circuit parts (1, 2).

2. Power supply apparatus according to claim 1, **wherein** the power supply apparatus comprises a switched mode power supply including a soft-start feature for a start-up.

3. Power supply apparatus according to claim 1 or 2, **wherein** at least two of the circuit parts are digital circuit parts (1, 2), which have a communication channel (data) for a data exchange during a normal operation mode.

4. Power supply apparatus according to claim 1, 2 or 3, **wherein** at least two of the circuit parts (1, 2) are arranged in parallel with regard to the supply voltage (Vcc).

5. Power supply according to one of the preceding claims, **wherein** the delay circuit (D) comprises a switching stage (Q1, Q2) and a voltage divider (R1, R2) for a delayed switching-through of the supply voltage (Vcc).

6. Power supply apparatus according to claim 5, **wherein** the delay circuit (D) comprises further a capacitor coupled to a control input of the switching stage (Q1, Q2), and the voltage divider (R1, R2) is coupled to an input (A) of the delay circuit (D) and to the control input of the switching stage (Q1, Q2) for providing a fraction of the input voltage (Vcc) to the control input of the switching stage (Q1, Q2).

7. Power supply apparatus according to one of the preceding claims, **wherein** one of the circuit parts (1) is a main circuit part and a second one of the circuit parts (2) is a minor circuit part, and the delay circuit (D) is arranged such, that the minor circuit part (2) is supplied later with the supply voltage (Vcc1) than the main circuit part (1).

8. Circuit arrangement comprising two circuit parts (1, 2) and a power supply apparatus according to one of the preceding claims.

9. Circuit arrangement according to claim 8, **wherein** the circuit arrangement is arranged within a digital audio amplifier.
